# FASCICULE DE BREVET EUROPEEN

(11) **EP 3 024 978 B1**
(45) Date de publication et mention de la délivrance du brevet: **11.04.2018**
(21) Numéro de dépôt: 14790133.4
(22) Date de dépôt: 11.07.2014
(51) Int. Cl.: D21H 25/04, C03C 17/00, C03C 17/28, D21H 25/06, D06M 13/00, D06M 13/184, D06M 13/248, D06M 15/05, D21H 17/08, D21H 17/09, D21H 17/11, D21H 17/14, D21H 17/17, D21H 17/25, D21H 17/00, D21H 19/10, D21H 19/14

(54) **PROCEDE DE FORMATION D'UNE COUCHE HYDROPHOBE**
VERFAHREN ZUR HERSTELLUNG EINER HYDROPHOBEN SCHICHT
METHOD FOR FORMING A HYDROPHOBIC LAYER

(30) Priorité: 26.07.2013 FR 1357375
(43) Date de publication de la demande: 01.06.2016
(73) Titulaire: Institut Polytechnique de Grenoble, 38000 Grenoble (FR)
(72) Inventeur: MISSOUM, Karim, 38100 Grenoble (FR); BRAS, Julien, 38410 St Martin d`Uriage (FR); BELGACEM, Naceur, F-38320 Brie Et Angonnes (FR)
(74) Mandataire: Thibon, Laurent
(86) Numéro de dépôt international: PCT/FR2014/051797
(87) Numéro de publication internationale: WO 2015/011364

(56) Documents cités:
- WO-A1-2007/088974
- WO-A1-2008/061003
- WO-A1-2012/085879

## Description

La présente demande de brevet revendique la priorité de la demande de brevet français FR13/57375 qui sera considérée comme faisant partie intégrante de la présente description.

### Domaine

La présente invention concerne un procédé de formation d'une couche hydrophobe sur un support.

### Exposé de l'art antérieur

De façon générale, on cherche souvent à former sur un support une couche fortement hydrophobe pour limiter son interaction avec l'eau (par exemple dans le textile, les pare-brise). Plus particulièrement, on peut souhaiter former une telle couche sur du papier pour lui conférer des propriétés hydrophobes, un papier étant naturellement hydrophile.

Pour atteindre ce résultat, on peut soit modifier chimiquement la surface, soit utiliser une sauce de couchage. Des exemples de sauce de couchage couramment utilisées sont des mélanges de liants tels que des latex (acrylique ou styrène-butadiène) ou des polymères hydrosolubles (amidon, CMC, PVA, caséine) et de charges pigmentaires minérales (carbonate de calcium broyé ou précipité, kaolin, talc, TiO₂) ou organiques. Certains adjuvants comme des dispersants, des azurants optiques, des antimousses, des insolubilisants, des lubrifiants, etc. peuvent être aussi ajoutés. Dans le cas des sauces de couchage, des polymères fluorés sont aussi utilisés. Dans tous les cas ces sauces sont non transparentes et non d'origine biologique ce qui limite leurs applications.

Il est également connu, pour protéger, étanchéifier, colorer des supports papier, de les revêtir d'un tapis de micro-fibres de cellulose, MFC, ou cellulose microfibrillée (en anglais MicroFibrillated Cellulose) additionnées notamment d'une charge.

Toutefois, les divers procédés de formation et de dépôt de couche hydrophobe décrits précédemment présentent les inconvénients d'être relativement complexes, et/ou de présenter des caractéristiques d'hydrophobie non optimales.

### Résumé

On cherche ici à simplifier et à améliorer les caractéristiques d'hydrophobie d'une couche de protection hydrophobe.

Selon un mode de réalisation de la présente invention, il est prévu un procédé de formation d'une couche hydrophobe filmogène sur un support, comprenant :
former une suspension aqueuse de nanofibres de cellulose, NFC dans lesquelles les NFC ont un diamètre compris dans une plage de 10 à 200 nm;
former, dans l'eau avec un solvant non miscible dans l'eau et ayant une température d'évaporation inférieure à celle de l'eau, une nanoémulsion cationique contenant un surfactant d'une substance pouvant former des liaisons covalentes avec la cellulose, dans laquelle les micelles de la nanoémulsion ont des dimensions du même ordre de grandeur que ledit diamètre;
mélanger la suspension et la nanoémulsion de manière à réaliser un mélange résultant d'une adsorption de ladite substance par les NFC ;
coucher ledit mélange sur un support ; et
procéder à un recuit propre à greffer ladite substance sur les NFC.

Selon un mode de réalisation, ladite substance est choisie dans le groupe comprenant AKD, ASA, chlorure d'acyle, isocyanate gras, acide carboxylique gras, thiocyanate, et anhydride gras, et ledit solvant est choisi dans le groupe comprenant : chloroforme, DMF, dichlorométhane, pentane, hexane, éthyl éther.

Selon un mode de réalisation, ladite substance est de l'AKD et ledit solvant est du chloroforme.

Selon un mode de réalisation, le support est du papier, du carton, du verre, un textile, une matière plastique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre des étapes successives de fabrication d'une nanoémulsion d'AKD ;
la figure 2A illustre des étapes successives de formation d'une solution de NFC-AKD ; et
la figure 2B représente l'allure des produits obtenus dans les diverses solutions énoncées en figure 2A ;
la figure 3 illustre des étapes successives de revêtement d'un support par une couche hydrophobe NFC-AKD ; et
la figure 4 représente une couche hydrophobe revêtant un support.

### Description détaillée

De façon générale, il est prévu ici de former une couche hydrophobe filmogène en mélangeant une nanoémulsion d'un dimère d'alkylcétène, couramment désigné par l'appellation AKD - de l'anglais Alkyl Ketene Dimer avec des nanofibres de cellulose.

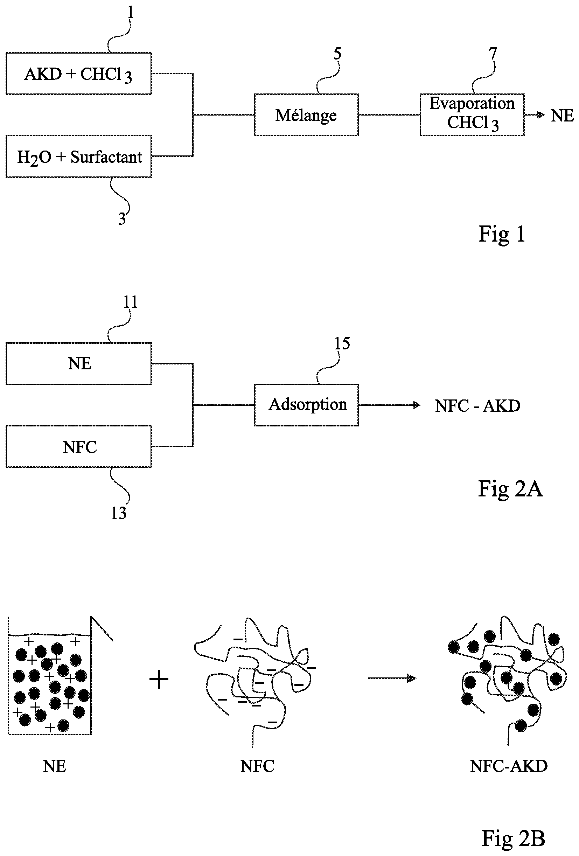

La figure 1 représente des étapes de formation de la nanoémulsion d'AKD. On utilise comme matériau de départ, d'une part une solution d'AKD dans du chloroforme, CHCl₃, (bloc 1) et d'autre part un surfactant cationique dissous dans l'eau (bloc 3). Le surfactant est par exemple du bromure de tétradécyltriméthylammonium (TTAB). Ces deux solutions sont mélangées (bloc 5) avec une agitation produite par ultrasons, par exemple, pendant plusieurs minutes. On cherche à obtenir des micelles d'un diamètre compris entre 50 et 400 nm et l'expérience montre que celles-ci peuvent être obtenues avec une bonne reproductibilité et une faible distribution de dimensions (inférieure à 10 %). Après cela (bloc 7) on procède à un chauffage à une température de l'ordre de 40 à 90°C, par exemple 70°C, pour évaporer le chloroforme. On obtient ainsi une nanoémulsion, NE, de micelles d'AKD lié à du surfactant, ces micelles étant chargées positivement.

Ensuite, comme l'illustre la figure 2, la nanoémulsion, NE, (bloc 11) obtenue à la suite des étapes décrites dans l'exemple de la figure 1, en suspension dans de l'eau est mélangée (bloc 13) avec une suspension aqueuse de nanofibres de cellulose, NFC. Les nanofibres de cellulose ont un diamètre inférieur au micromètre de préférence de l'ordre de 5 à 200 nm, de préférence 10 à 60 nm. Ces nanofibres de cellulose sont obtenues par tout procédé connu, à partir de pulpe de bois, par exemple une pulpe d'épicéa et de pin. Leur état de surface est de préférence modifié en utilisant par exemple des fibres dites TEMPO-oxydées, c'est-à-dire oxydées en présence de 2,2,6,6-tétraméthyl pipéridine1-oxyle ou en utilisant un traitement enzymatique. La proportion de nanofibres dans l'eau est par exemple de l'ordre de 1 à 5 % en poids. Le mélange (bloc 15) de nanofibres et d'AKD, NFC-AKD, est effectué à basse température (inférieure à 40°C), pour obtenir seulement un phénomène d'adsorption des micelles d'AKD par les nanofibres de cellulose. La température est maintenue suffisamment basse pendant le mélange pour qu'il ne se produise pas de greffage (que la micelle ne coalesce pas sur la fibre). Ainsi, la liaison entre les micelles et les nanofibres est purement électrostatique.

La figure 2B représente très schématiquement l'allure (i) de la nanoémulsion, NE, une ou plusieurs charges positives étant liées à chaque micelle, (ii) d'un groupe de nanofibres de cellulose, NFC, dont chaque fibre porte un ensemble de charges négatives, et (iii) de la structure adsorbée, NFC-AKD, dans laquelle des micelles de nanoémulsion représentées par des ronds noirs sont liées électrostatiquement à des nanofibres de cellulose.

Un avantage du mélange NFC-AKD obtenu par adsorption est qu'il est extrêmement stable dans le temps. Il peut demeurer de façon non affectée pendant une durée d'une à plusieurs semaines. En outre, la concentration du mélange dans l'eau peut être relativement élevée, de 5 à 10 % en poids, tout en conservant une relativement faible viscosité (par exemple 0,155 Pa.s pour une concentration de 5 % de NFC-AKD pour une vitesse de cisaillement de 100 s⁻¹).

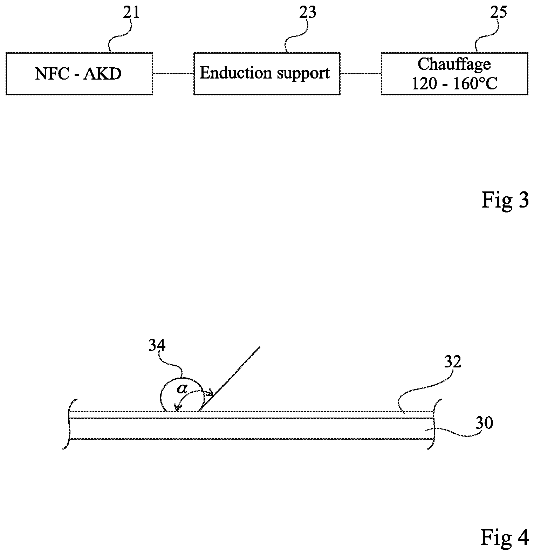

Comme l'illustre la figure 3, le mélange NFC-AKD (bloc 21) peut être utilisé directement pour enduire directement un support (bloc 23) dont on veut rendre la ou les surfaces enduites hydrophobes. Contrairement aux autres solutions de modifications chimiques des NFC pour les rendre hydrophobes, cette couche hydrophobe présente de bonnes qualités filmogènes, c'est-à-dire qu'elle se dépose en une couche régulière et ne se divise pas en micro "grumeaux" ou agglomérats. En effet, jusqu'à maintenant toute modification chimique effectuée dans le but de rendre hydrophobe les NFC ne permettait pas la conservation de propriétés filmogènes : une poudre était obtenue.

Ensuite seulement (bloc 25), une fois la couche de NFC-AKD déposée par tout procédé classique, par exemple par couchage à la barre, on procède à un recuit à une température de l'ordre de 110 à 150°C pour que la liaison électrostatique entre les micelles d'AKD et les NFC se transforme en un greffage chimique - une liaison covalente. La couche est alors définitivement stabilisée.

Un avantage de ce processus est que l'on peut déposer une couche extrêmement mince, d'une épaisseur de l'ordre de 0,2 à 5 µm, cette épaisseur étant conservée après greffage.

Un autre avantage de ce processus est qu'il n'est pas nécessaire de prévoir l'adjonction de produits généralement présents dans une sauce de couchage, tels qu'énoncés en tête de la présente description.

La figure 4 représente un support 30, par exemple une lame de verre ou une feuille de papier revêtue d'une couche 32 obtenue par le procédé décrit en relation avec les figures 1 à 3. On a représenté sur la couche 32 une goutte d'eau 34 dont les bords forment avec la surface de la couche 32 un angle α obtus, caractéristique d'un revêtement hydrophobe. Cet angle pourra par exemple être de l'ordre de 90 à 140°.

On a décrit précédemment un mode de réalisation particulier de la présente invention. Diverses variantes et modifications apparaîtront à l'homme de l'art. En particulier, pour former la nanoémulsion, au lieu de partir d'AKD dissous dans du chloroforme, on pourra utiliser toute substance polarisée susceptible de former des liaisons covalentes avec la cellulose pour se greffer sur celle-ci. Cette substance pourra être choisie dans le groupe comprenant AKD, ASA, chlorure d'acyle, isocyanate gras, acide carboxylique gras, thiocyanate, et anhydride gras. De même, cette substance pourra être dissoute dans d'autres solvants que le chloroforme. Il importe seulement que ce solvant soit non miscible dans l'eau et ait une température d'évaporation inférieure à celle de l'eau. On pourra par exemple choisir un solvant dans le groupe comprenant : chloroforme, DMF, dichlorométhane, pentane, hexane, éthyl éther.

## Revendications

1. Procédé de formation d'une couche hydrophobe filmogène sur un support, comprenant :
former une suspension aqueuse de nanofibres de cellulose, NFC dans lesquelles les NFC ont un diamètre compris dans une plage de 10 à 200 nm ;
former, dans l'eau avec un solvant non miscible dans l'eau et ayant une température d'évaporation inférieure à celle de l'eau, une nanoémulsion cationique contenant un surfactant d'une substance pouvant former des liaisons covalentes avec la cellulose, dans laquelle les micelles de la nanoémulsion ont des dimensions du même ordre de grandeur que ledit diamètre ;
mélanger la suspension et la nanoémulsion de manière à réaliser un mélange résultant d'une adsorption de ladite substance par les NFC ;
coucher ledit mélange sur un support ; et
procéder à un recuit propre à greffer ladite substance sur les NFC.

2. Procédé selon la revendication 1, dans lequel :
ladite substance est choisie dans le groupe comprenant AKD, ASA, chlorure d'acyle, isocyanate gras, acide carboxylique gras, thiocyanate, et anhydride gras, et
ledit solvant est choisi dans le groupe comprenant : chloroforme, DMF, dichlorométhane, pentane, hexane, éthyl éther.

3. Procédé selon la revendication 2, dans lequel ladite substance est de l'AKD et ledit solvant est du chloroforme.

4. Procédé selon l'une quelconque des revendications 1 à 3, dans lequel le support est du papier, du carton, du verre, un textile, une matière plastique.

## Patentansprüche

1. Ein Verfahren zur Bildung einer filmbildenden hydrophoben Schicht auf einem Substrat, das Folgendes aufweist:
Bilden einer wässrigen Suspension aus Cellulose-Nanofasern, CNFs, wobei die CNFs einen Durchmesser in dem Bereich von 10 bis 200 nm aufweisen.
Bilden in Wasser mit einem mit Wasser nicht mischbaren Lösungsmittel, das eine Verdampfungstemperatur besitzt, die unter derjenigen von Wasser liegt, einer kationische Nanoemulsion, die ein Netzmittel einer Substanz aufweist, das geeignet ist, kovalente Bindungen mit Cellulose zu bilden, in welchen die Mizellen der Nanoemulsion Abmessungen der gleichen Größenordnung wie der Durchmesser besitzen;
Mischen der Suspension und der Nanoemulsion, um eine Mischung resultierend aus einer Adsorption der Substanz durch die CNFs zu formen;
Beschichten eines Substrats mit der Mischung; und
Durchführen einer Temperaturbehandlung, die geeignet ist, die Substanz an die CNFs anzubinden.

2. Verfahren nach Anspruch 1, wobei:
die Substanz aus der Gruppe ausgewählt ist, die AKD, ASA, Acylchlorid, Fettisocyanat, Fettkarboxylsäure, Thiocyanat und Fettanhydrid aufweist, und
das Lösungsmittel aus der Gruppe ausgewählt ist, die Chloroform, DMF, Dichlormethan, Pentan, Hexan, Ethyläther aufweist.

3. Verfahren nach Anspruch 2, wobei die Substanz AKD ist und das Lösungsmittel Chloroform ist.

4. Verfahren nach einem der Ansprüche 1 bis 3, wobei das Substrat Papier, Pappe, Glas, ein Textil- oder Plastikmaterial ist.

## Claims

1. A method of forming a film-forming hydrophobic layer on a substrate, comprising:
forming an aqueous suspension of cellulose nanofibers, CNFs wherein the CNFs have a diameter in a range from 10 to 200 nm;
forming, in water with a water-immiscible solvent having an evaporation temperature lower than that of water, a cationic nanoemulsion containing a surfactant of a substance capable of forming covalent bonds with cellulose, in which the micelles of the nanoemulsion have dimensions of the same order of magnitude as said diameter;
mixing the suspension and the nanoemulsion to form a mixture resulting from an adsorption of said substance by the CNFs;
coating a substrate with said mixture; and
performing an anneal capable of grafting said substance on the CNFs.

2. The method of claim 1, wherein:
said substance is selected from the group comprising AKD, ASA, acyl chloride, fatty isocyanate, fatty carboxylic acid, thiocyanate, and fatty anhydride, and
said solvent is selected from the group comprising: chloroform, DMF, dichloromethane, pentane, hexane, ethyl ether.

3. The method of claim 2, wherein said substance is AKD and said solvent is chloroform.

4. The method of any of claims 1 to 3, wherein the substrate is paper, cardboard, glass, a textile, a plastic material.
